# DEMANDE DE BREVET EUROPEEN

(11) **EP 0 539 851 A1**
(43) Date de publication de la demande: **05.05.1993**
(21) Numéro de dépôt: 92117964.4
(22) Date de dépôt: 21.10.1992
(51) Int. Cl.: H05K 13/04, B23K 3/047

(54) **Procédé de soudage d'un composant électronique sur un substrat et dispositif de soudage comprenant une tête de soudage avec des thermodes écartables permettant la mise en oeuvre de ce procédé de soudage**

(30) Priorité: 01.11.1991 CH 3204/91; 15.11.1991 FR 9114204
(71) Demandeur: SMH ENGINEERING AG, CH-2540 Grenchen (CH)
(72) Inventeur: Matthey-Doret, Fernand, CH-2400 Le Locle (CH); Baldelli, Franco, CH-2400 Le Locle (CH)
(74) Mandataire: Caron, Gérard

(57) **Abrégé**

L'invention concerne un procédé de soudage d'un composant électronique permettant pendant le soudage le maintien du composant électronique dans la position d'alignement de ses pattes de connexion sur les extrémités des connexions externes du substrat.

L'invention concerne aussi une tête de soudage à thermodes écartables et un dispositif de soudage comprenant une telle tête de soudage, ce dispositif de soudage permettant la mise en oeuvre du procédé de soudage selon l'invention.

## Description

La présente invention concerne un procédé de soudage pour souder par effet Joule les pattes de connexion d'un composant électronique à des connexions externes situées sur un substrat, ainsi qu'une tête de soudage et un dispositif de soudage pour la mise en oeuvre de ce procédé.

Dans ce domaine technique, les dispositifs de soudage connus, comme celui décrit dans le document FR 2 496 519, utilisent des têtes de soudage comprenant une seule thermode monobloc appropriée à un seul type de composants électroniques.

Les diverses étapes du procédé de soudage d'un composant électronique à l'aide d'un tel dispositif de soudage sont généralement les suivantes : une pipette de préhension saisit un composant électronique par aspiration et l'amène au-dessus du substrat sur lequel il doit être soudé. A l'aide de moyens de visualisation, les pattes de connexion du composant électronique sont alignées sur les connexions externes du substrat. Ensuite, la pipette de préhension dépose le composant électronique sur le substrat. La pipette de préhension lâche alors ce composant électronique et est retirée pour laisser la place à la tête de soudage qui est déplacée jusqu'au dessus du composant électronique à souder, puis descendue jusqu'à ce que les pannes de soudage de la thermode monobloc soient en contact thermique avec les pattes de connexion du composant électronique. Finalement le soudage est effectué et la thermode est retirée.

Ce procédé de soudage présente divers inconvénients. Premièrement, étant donné qu'il est nécessaire d'arrêter l'aspiration de la pipette de préhension du composant électronique pour pouvoir retirer cette pipette et permettre à la tête de soudage d'être superposée au composant électronique, il y a un risque non négligeable que, lors de l'arrêt de l'aspiration, le composant électronique bouge quelque peu, entraînant ainsi une perturbation de l'alignement des pattes de connexion de ce composant électronique avec les connexions externes du substrat. Deuxièmement, lorsque les pannes de soudage de cette tête de soudage sont amenées en appui sur les pattes de connexion du composant électronique, la pression exercée par ces pannes de soudage sur les pattes de connexion du composant peut provoquer un glissement de ces pattes de connexion sur des gouttes d'étain situées aux extrémités des connexions externes et sur lesquelles les pattes de connexion du composant électronique doivent être soudées.

L'inconvénient majeur dans ce procédé de soudage d'un composant électronique sur un substrat vient donc du fait que le composant électronique est lâché sur le site où il doit être soudé et qu'il est libre au moment où la tête de soudage vient appliquer ses pannes de soudage sur les pattes de connexion de ce composant.

Le but de la présente invention est de pallier les inconvénients décrits ci-dessus en proposant un procédé de soudage dans lequel le composant électronique est maintenu par le moyen de préhension de ce composant électronique jusqu'à ce que les pattes de connexion de ce dernier soient soudées aux connexions externes se trouvant sur le substrat.

Ensuite, un autre but de cette invention est de proposer une tête de soudage et un dispositif de soudage comprenant une telle tête de soudage et permettant de mettre en oeuvre le procédé de soudage selon l'invention.

La présente invention a donc pour objet un procédé de soudage d'un composant électronique sur un substrat comprenant les étapes successives suivantes :
- préhension du composant électronique sur un site de présentation par un élément de préhension comprenant un bras terminal perpendiculaire au plan défini par les parties de contact des pattes de connexion du composant électronique;
- transfert du composant électronique au moyen de l'élément de préhension au-dessus d'un site de soudage appartenant au substrat, lequel comprend un ensemble de connexions externes aux extrémités desquelles il est prévu de souder les parties de contact des pattes de connexion;
- alignement des parties de contact des pattes de connexion avec les extrémités des connexions externes au moyen d'un dispositif d'alignement;
- fermeture de thermodes écartables sur le bras terminal de l'élément de préhension de telle manière que des pannes de soudage de ces thermodes écartables soient au moins partiellement superposées et à au moins un ensemble des parties de contact des pattes de connexion du composant électronique et pose des parties de contact des pattes de connexion sur les extrémités des connexions externes;
- déplacement des thermodes écartables jusqu'à ce que les surfaces de contact des pannes de soudage soient en contact thermique avec les parties de contact des pattes de connexion du composant électronique;
- soudage des parties de contact des pattes de connexion aux extrémités des connexions externes;
- retrait des thermodes écartables pour éloigner les pannes de soudage de ces thermodes écartables des pattes de connexion et lâcher du composant électronique.

On notera que la fermeture des thermodes écartables peut être antérieure ou postérieure à la pose des parties de contact des pattes de connexion sur les extrémités des connexions externes du substrat. Il en va de même pour le retrait des thermodes écartables et le lâcher du composant électronique.

Afin de permettre le soudage d'un autre composant électronique, des étapes terminales, notamment l'ouverture des thermodes écartables et le retour du moyen de préhension au-dessus du site de présentation, sont prévues dans une variante cyclique du procédé de soudage selon l'invention.

La présente invention a également pour objet une tête de soudage caractérisée en ce qu'elle comprend au moins deux thermodes écartables et des moyens d'ouverture et de fermeture capable d'engendrer un déplacement relatif d'au moins une de ces thermodes écartables par rapport à au moins une autre de ces thermodes écartables entre une position fermée correspondant à la configuration de travail des pannes de soudage de ces thermodes écartables et une position ouverte dans laquelle ces thermodes écartables sont écartées l'une de l'autre, ces thermodes définissant dans la position fermée une région centrale entourant un axe central et laissée libre pour permettre à un bras terminal d'un élément de préhension d'un composant électronique de traverser selon la direction de l'axe central cette région centrale lorsque la tête de soudage est dans la position fermée, chacune de ces thermodes écartables étant reliée électriquement à une alimentation électrique.

Selon un mode de réalisation particulier de l'invention, la tête de soudage selon l'invention comprend deux thermodes écartables, chacune de ces deux thermodes écartables comportant deux pannes de soudage avec un profil rectiligne disposées orthogonalement l'une par rapport à l'autre et étant reliée à une alimentation électrique qui lui est propre. Une variante de ce mode de réalisation consiste à mettre trois pannes de soudage sur la première thermode et seulement une panne de soudage sur la seconde thermode.

Dans un mode de réalisation préféré de l'invention, la tête comprend quatre thermodes écartables comprenant chacune une panne de soudage servant à souder par effet Joule les pattes de connexion d'un composant électronique sur les extrémités de connexions externes d'un substrat, chaque thermode étant reliée de manière solidaire à une alimentation électrique, par exemple une bobine, et portée par un porte-thermode. Deux porte-thermode sont fixés à un premier carter et les deux autres porte-thermode sont fixés à un second carter, chaque porte-thermode étant solidaire du carter auquel il est fixé. Les premier et second carters sont associés à un vérin servant de moyen d'ouverture et de fermeture de la tête de soudage. Ce vérin permet un déplacement relatif des deux carters selon une direction privilégiée.

En outre, chaque porte-thermode peut comprendre une coulisse associée à un vernier permettant de varier le positionnement de la panne de soudage de la thermode montée sur ce porte-thermode par rapport au carter sur lequel ce porte-thermode est fixé, ce qui donne un degré de liberté propre à chacune des thermodes écartables.

La tête de soudage selon ce mode de réalisation préféré de l'invention est conçue de telle manière qu'un bras terminal d'un moyen de préhension du composant électronique destiné à être soudé sur le substrat puisse être introduit latéralement dans la région centrale de cette tête de soudage par une ouverture sur un côté de cette tête de soudage lorsque les deux carters de celle-ci sont dans une position ouverte. Cette tête de soudage est également conçue de telle manière que, dans la position ouverte, il y ait un champ visuel suffisant selon la direction de l'axe central de cette tête de soudage pour permettre un alignement sans erreur de parallaxe des pattes de connexion du composant électronique sur les extrémités des connexions externes du substrat au moyen d'un dispositif de visualisation, par exemple une caméra ou une binoculaire, placé au-dessus de la tête de soudage, le dessous de cette tête de soudage étant défini par l'emplacement des pannes de soudage de cette tête de soudage.

On notera que dans ce mode de réalisation préféré d'une tête de soudage selon l'invention, une variante consiste à placer trois porte-thermode sur un premier carter et seulement un porte-thermode sur un second carter.

La présente invention a encore pour objet un dispositif de soudage comprenant :
- une tête de soudage;
- des moyens de préhension d'un composant électronique susceptible d'être déplacé horizontalement et verticalement par rapport à un substrat destiné à recevoir le composant électronique;
- une table destinée à supporter le substrat, cette table étant susceptible d'être déplacée selon deux directions perpendiculaires dans le plan de cette table et de subir une rotation dans ce plan;
- un dispositif de visualisation permettant de visualiser un site de soudage;
- un moteur permettant au moins un déplacement vertical selon la direction d'un axe central de la tête de soudage entre une position de soudage et une position de mise en place du composant électronique dans laquelle la tête de soudage est éloignée du substrat;
ce dispositif de soudage étant caractérisé en ce que la tête de soudage est une tête de soudage à thermodes écartables selon l'invention.

Dans un mode de réalisation préféré du dispositif de soudage selon l'invention, le dispositif de visualisation du site de soudage est situé au-dessus de la tête de soudage, cette tête de soudage présentant une ouverture suffisante dans la position ouverte pour permettre à ce dispositif de visualiser selon la direction de l'axe central au moins une partie du site de soudage pour garantir un alignement parfait des pattes de connexion du composant électronique sur les extrémités des connexions externes du substrat.

En outre, ce dispositif de soudage peut comprendre une commande de régulation servant à régler la puissance d'alimentation des bobines d'alimentation en fonction de l'information transmise par des thermocouples placés sur les pannes de soudage de la tête de soudage, ainsi qu'à régler les déplacements de la tête au moyen du moteur de manière optimale, et ceci spécialement lorsque la tête de soudage est approchée du composant électronique posé sur le site de soudage.

Cette commande de régulation permet de régler la pression exercée par les pannes de soudage sur les pattes de connexion du composant électronique lors du soudage en fonction du temps et de la température des pannes de soudage, le soudage pouvant ainsi être effectué par paliers successifs.

Dans ce mode de réalisation préféré du dispositif de soudage, on peut aussi prévoir une visualisation intelligente pour l'alignement des pattes de connexion sur les extrémités des connexions externes du substrat.

Il résulte des caractéristiques de l'invention décrite ci-avant un procédé de soudage permettant de maintenir dans une position fixe et déterminée le composant électronique lors du soudage de ses pattes de connexions aux extrémités des connexions externes du substrat, ce qui garantit un soudage précis et fiable.

Il résulte aussi des caractéristiques de l'invention décrite ci-avant une tête de soudage permettant à un moyen de préhension d'un composant électronique, par exemple une pipette aspirante terminée par une ventouse, d'être introduite dans la région centrale de la tête de soudage lorsque celle-ci est ouverte et ensuite de pouvoir rester dans cette région centrale lorsque cette tête de soudage est dans une position fermée. De plus, en prévoyant un bras terminal du moyen de préhension qui soit régulier et parallèle à l'axe central de cette tête de soudage, il est alors possible de déplacer, selon la direction de cet axe central, la tête de soudage, rendant ainsi possible le maintien du composant électronique sur le site de soudage pendant la phase de soudage de ce composant électronique.

Dans le mode de réalisation préféré de la tête de soudage décrit ci-avant, la tête de soudage offre en plus dans sa position ouverte un champ visuel selon la direction de l'axe central et depuis le dessus de cette tête qui est suffisant pour garantir un alignement parfait des parties de contact des pattes de connexion du composant électronique aux extrémités des connexions externes du substrat, sans pour autant devoir déplacer la tête de soudage dans un plan parallèle au substrat.

D'autres caractéristiques de l'invention apparaîtront mieux à la lecture de la description détaillée qui suit faite en référence aux dessins annexés qui sont donnés uniquement à titre d'exemple et dans lesquels :
- les figures 1 à 4 sont des représentations schématiques de diverses étapes d'un premier mode de mise en oeuvre du procédé de soudage d'un composant électronique sur un substrat selon l'invention;
- la figure 5 est une vue partiellement éclatée de diverses parties d'un premier mode de réalisation d'une tête de soudage à thermodes écartables selon l'invention, cette tête de soudage étant dans une position ouverte;
- la figure 6, respectivement 7 est une vue en perspective et partielle de la tête de soudage à thermodes écartables de la figure 5, cette tête de soudage étant dans une position ouverte, respectivement fermée;
- les figures 8 et 9 sont des vues de côté d'une variante de réalisation d'une thermode comprise dans le premier mode de réalisation d'une tête de soudage à thermodes écartables selon l'invention;
- la figure 10 est une vue en perspective de la thermode des figures 8 et 9 et de son alimentation montées sur un porte-thermode.
- la figure 11 représente l'objet de la figure 10 coupé selon le plan de symétrie XI-XI de la thermode donné sur la figure 8;
- la figure 12, respectivement 13 est une vue de face des quatre thermodes d'une première, respectivement deuxième variante du premier mode de réalisation d'une tête de soudage à thermodes écartables selon l'invention, ces thermodes étant représentées dans une position fermée;
- la figure 14 est une représentation schématique et partielle d'un dispositif de soudage selon l'invention.

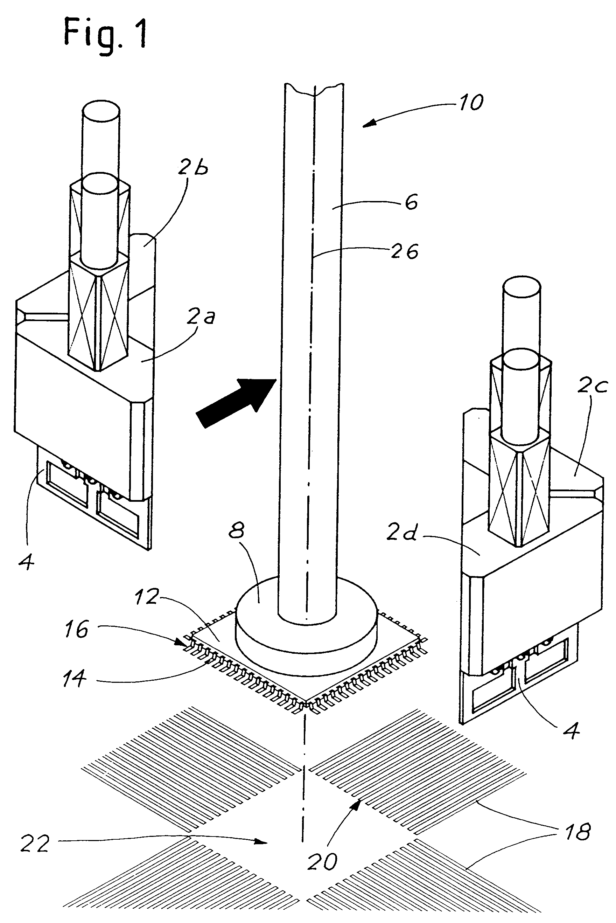

En se référant aux figures 1 à 4, on décrira ci-après un premier mode de mise en oeuvre du procédé de soudage selon l'invention.

Sur ces quatre figures sont représentées schématiquement pour décrire ce premier mode de mise en oeuvre du procédé de soudage selon l'invention quatre thermodes de soudage 2a à 2d comprenant chacune un élément de chauffage 4 formé par une plaquette ajourée appelée panne de soudage, laquelle définit une surface de contact 5, ainsi qu'un bras terminal 6 et un organe de préhension 8 d'un élément de préhension 10 d'un composant électronique 12. Le composant électronique 12 comprend des pattes de connexion 14 comprenant chacune une partie de contact 16. Les connexions externes 18 aux extrémités 20 desquelles les parties de contact 16 des pattes de connexion 14 doivent être soudées ont été représentées partiellement, ces connexions externes 18 étant situées sur un substrat (non représenté). Les extrémités 20 de ces connexions externes 18 définissent un site de soudage 22.

Dans ce premier mode de mise en oeuvre du procédé de soudage selon l'invention, le composant électronique 12 est amené au-dessus du site de soudage 22 au moyen de l'élément de préhension 10 en subissant un mouvement de translation horizontale, c'est-à-dire dans un plan parallèle au site de soudage. Lors de l'introduction du composant électronique 12 au-dessus du site de soudage 22, les thermodes de soudage 2a à 2d sont dans une position ouverte.

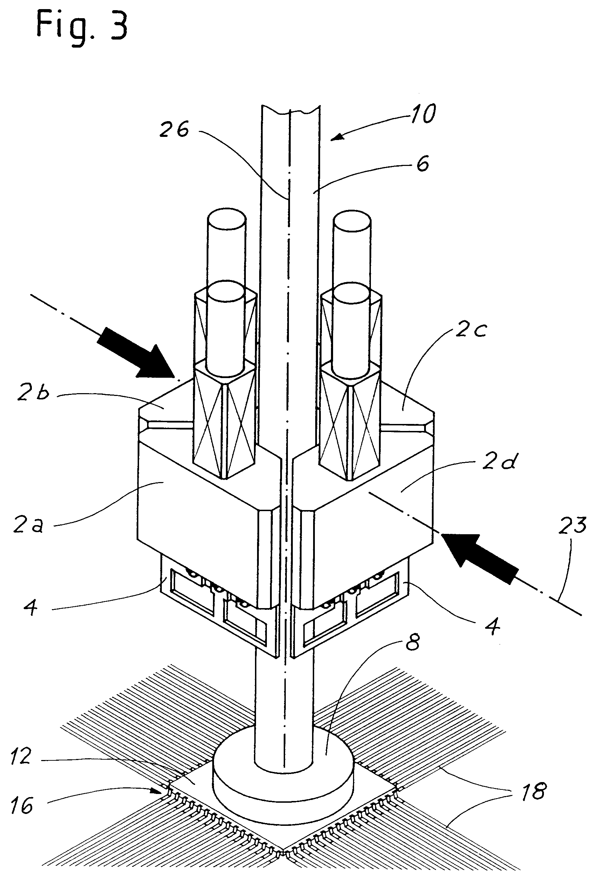

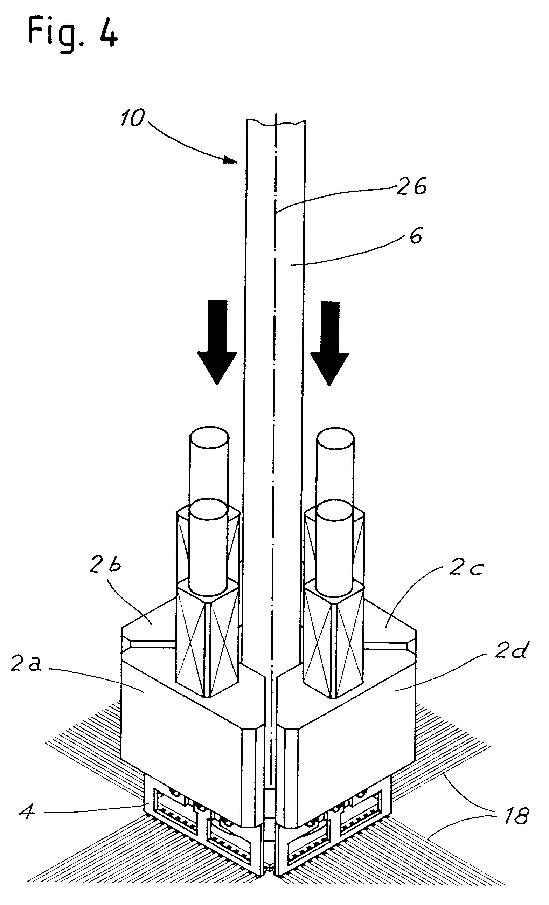

On notera que l'élément de préhension 10 a transféré le composant électronique 12 depuis un site de présentation sur lequel ce composant électronique 12 a été orienté de manière adéquate par rapport à l'orientation des pannes de soudage 4 des thermodes 2a à 2d lorsqu'elles sont dans une position fermée comme représenté sur les figures 3 et 4. Pour orienter correctement le composant électronique 12 sur le site de présentation, un dispositif d'orientation du composant électronique 12 sur ce site de présentation peut être prévu.

Une fois le composant électronique 12 amené au-dessus du site de soudage 22 par l'élément de préhension 10, il est prévu un alignement des parties de contact 16 des pattes de connexion 14 de ce composant électronique 12 sur les extrémités correspondantes 20 des connexions externes 18 par un dispositif d'alignement.

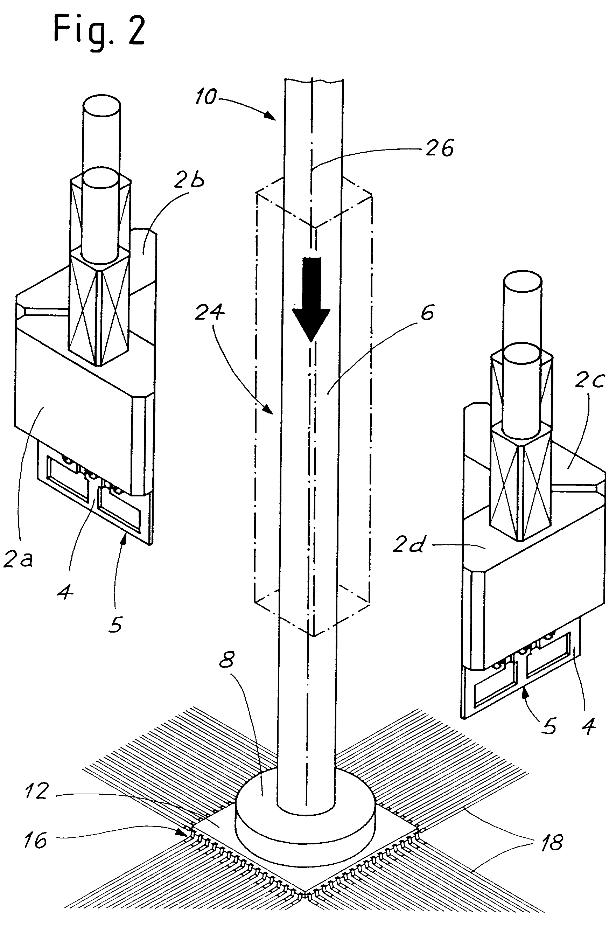

Une fois l'alignement effectué, les parties de contact 16 des pattes de connexions 14 sont amenées en contact avec les extrémités correspondantes 20 des connexions externes 18 au moyen de l'élément de préhension 10 qui subit un déplacement selon un axe central 26, comme cela est schématisé sur la figure 2. Une fois cette étape de pose des parties de contact 16 des pattes de connexion 14 sur les extrémités correspondantes 20 des connexions externes 18 effectuée, les quatre thermodes 2a à 2d sont alors fermées selon une direction privilégiée 23, comme cela est schématisé sur la figure 3. Dans leur position fermée, les quatre surfaces latérales de ces quatre thermodes définissent une région centrale 24 entourant l'axe central 26 sur lequel le bras terminal 6 de l'élément de préhension 10 est aligné une fois qu'il a transféré le composant électronique 12 au-dessus du site de soudage 22. Dans la position de soudage du composant électronique 12, le bras terminal 6 de l'élément de préhension 10 traverse donc la région centrale 24 entourant l'axe central 26, sans que ce bras terminal 6 intercepte les parois latérales de cette région centrale 24A, ce qui permet aux thermodes 2a à 2d d'être refermées sur ce bras terminal 6.

Une fois les thermodes 2a à 2d placées dans une position fermée, elles subissent un mouvement de translation selon la direction de l'axe central 26 jusqu'à ce que les pannes de soudage 4 soient en contact thermique avec les parties de contact 16 des pattes de connexion 14 du composant électronique 12, comme cela est schématisé sur la figure 4. A nouveau, la partie du bras terminal 6 qui travers la région centrale 24 lors de ce mouvement de translation n'intercepte jamais les parois latérales de cette région centrale 24. Une fois cette étape réalisée, le soudage du composant électronique 12 sur le site de soudage 22 peut être effectué. On notera que lors du soudage, un léger déplacement de la tête de soudage selon la direction de l'axe central est possible si cela est nécessaire pour la qualité du soudage.

Une fois le soudage effectué, les thermodes 2a à 2d subissent à nouveau une translation selon l'axe central 26 de manière à éloigner ces thermodes 2a à 2d du site de soudage 22. Ensuite, les thermodes 2a à 2d sont écartées et le moyen de préhension 10 lâche le composant électronique. Le moyen de préhension 10 est alors éloigné à son tour de ce site de soudage 22 pour être ramené sur le site de présentation d'un composant électronique, ce qui finit le cycle de soudage de ce mode de mise en oeuvre du procédé de soudage selon l'invention, permettant ainsi une répétition cyclique du procédé.

Dans ce premier mode de mise en oeuvre du procédé de soudage selon l'invention, on a représenté quatre thermodes, les deux thermodes 2a et 2b, respectivement 2c et 2d étant solidaires l'une de l'autre. Cependant, il est tout à fait possible d'effectuer le procédé de soudage de l'invention avec deux, voire trois thermodes ou plus de quatre thermodes, chaque thermode ayant une ou plusieurs pannes de soudage. D'un autre côté, il est aussi possible d'avoir deux unités écartables, l'une formée de trois thermodes solidaires l'une de l'autre et l'autre d'une quatrième thermode.

Il est aussi possible que les quatre thermodes soient indépendantes et écartables l'une de l'autre. Finalement, il n'est pas nécessaire que le transfert du composant électronique sur le site de soudage se fasse de manière transversale, une introduction par le dessus des thermodes étant par exemple possible.

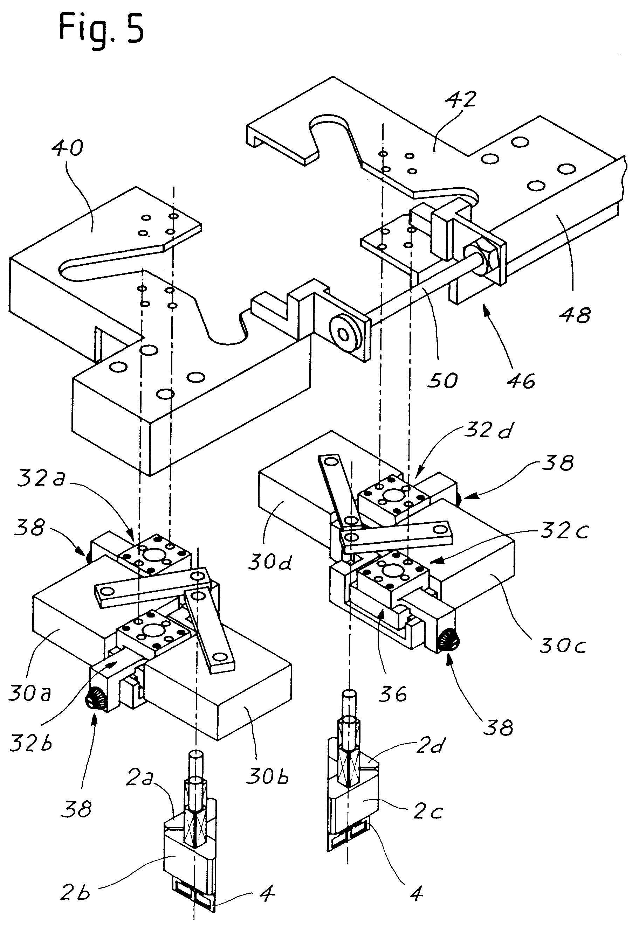

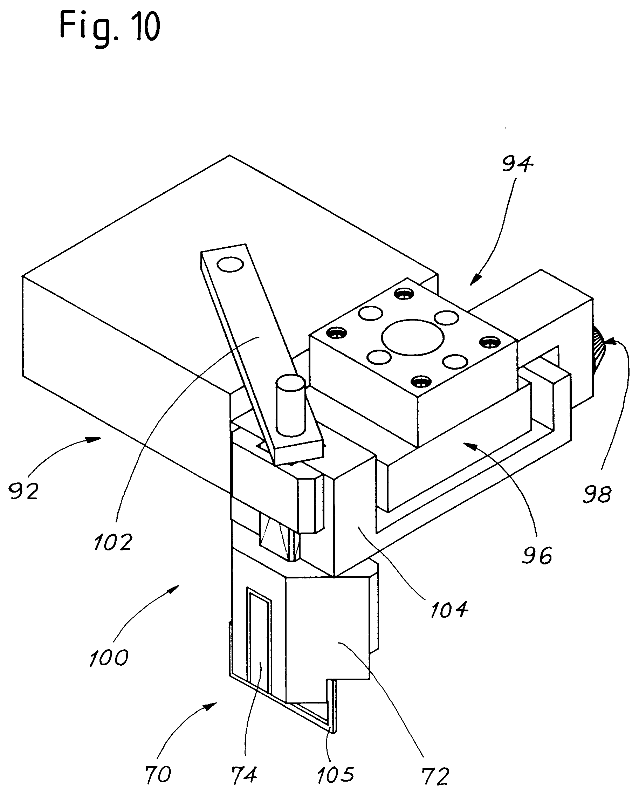

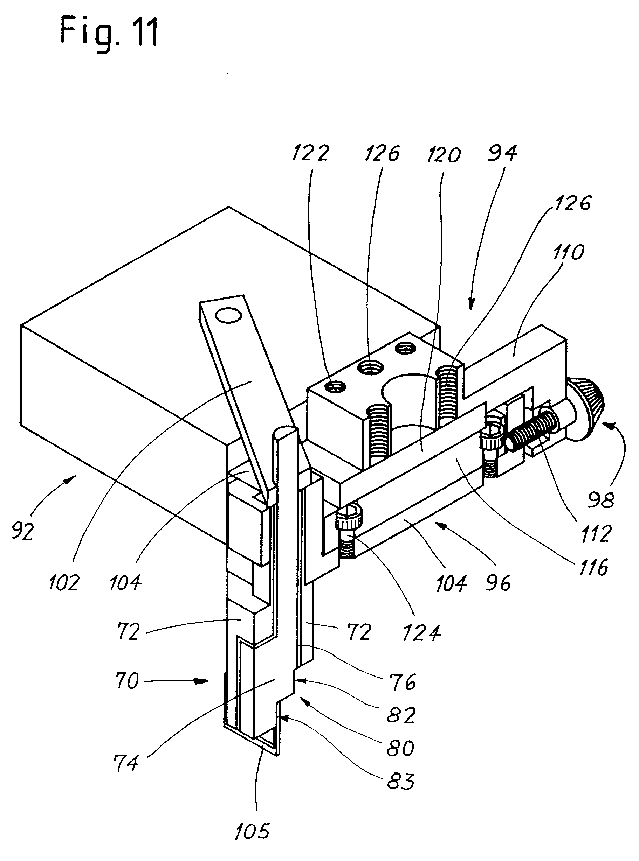

En se référant aux figures 5 à 11, on décrira ci-après un premier mode de réalisation d'une tête de soudage selon l'invention. Ce premier mode de réalisation d'une tête de soudage selon l'invention est conçu de telle manière qu'il permette l'ouverture et la fermeture des quatre thermodes 2a à 2d représentées sur les figures 1 à 4 utilisées pour décrire le procédé de soudage selon l'invention. Cette tête de soudage comprend ainsi quatre thermodes 2a à 2d, les thermodes 2a et 2b, respectivement 2c et 2d étant solidaires l'une de l'autre. Comme le montre la vue éclatée et partielle de la figure 5, chacune des quatre thermodes 2a à 2d est reliée électriquement de manière rigide à une alimentation électrique 30a à 30d qui lui est propre, laquelle est formée par une bobine, chacune de ces thermodes et l'alimentation correspondante étant montées sur un porte-thermode 32a à 32d. Chaque thermode 2a à 2d et l'alimentation correspondante 30a à 30d sont susceptibles d'être déplacées relativement au porte-thermode 32a à 32d sur lequel elles sont montées, grâce à une coulisse 36 associée à un vernier 38. Chaque thermode et son alimentation correspondante montées ensemble sur un porte-thermode 32a à 32d comprenant une coulisse 36 et un vernier 38 forment une unité de base 100 décrite de manière.plus détaillée sur les figures 10 et 11.

Les porte-thermode 32a et 32b, respectivement 32c et 32d sont fixés sur un premier, respectivement second carter 40, 42. Ces premier et second carters sont associés à un vérin 46 comprenant un cylindre 48 et un piston 50, le premier carter 40 étant relié rigidement au piston 50 du vérin 46, alors que le second carter 42 est relié rigidement au cylindre 48 de ce vérin 46.

On notera que les porte-thermode 32a à 32b comprenant chacun une coulisse et un vernier correspond à un perfectionnement de la tête de soudage selon l'invention caractérisée par le fait qu'elle comprend des thermodes écartables.

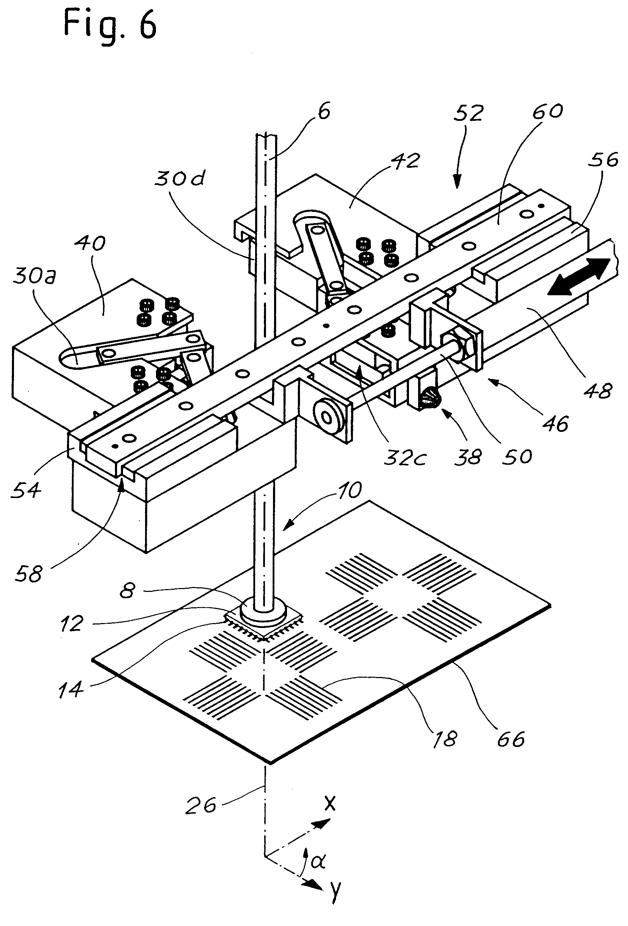

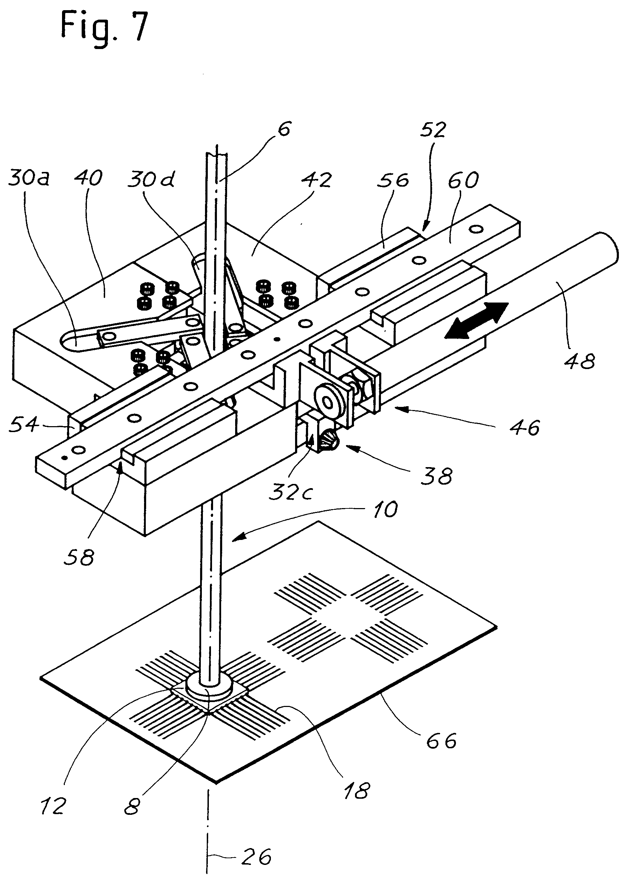

Sur les figures 6 et 7 où les deux niveaux supérieurs de la vue éclatée de la figure 5 sont assemblés, une coulisse 52, comprenant une première, respectivement seconde pièce 54, 56 comprenant chacune une rainure 58 dans laquelle prend place un rail de guidage 60, est fixée sur le premier, respectivement second carter 40, 42. Cette coulisse 52 associée au vérin 46 permet ainsi une ouverture et une fermeture des thermodes 2a à 2d selon une direction privilégiée correspondant à la direction longitudinale du rail de guidage 60.

On notera que les diverses parties représentées sur les figures 5 à 7 sont montées sur un bâti (non représenté) et que des butées réglables (également non représentées) sont prévues pour définir la position ouverte et la position fermée de cette tête de soudage relativement au rail de guidage 60.

Sur ces figures 6 et 7 ont aussi été représentés des éléments correspondant aux éléments des figures 1 à 4, à savoir le bras terminal 6 de l'élément de préhension 10 avec un composant électronique 12 et des connexions externes 18. Ces connexions externes 18 sont situées à la surface d'un substrat 66 susceptible de subir un déplacement dans son plan selon les axes X et Y, ainsi qu'une rotation a autour de l'axe central 26 pour permettre un alignement des pattes de connexion 14 du composant électronique 12 avec les extrémités des connexions externes correspondantes 18. La tête de soudage dans la configuration de la figure 6, respectivement 7 correspond à une position ouverte, respectivement fermée de cette tête de soudage 6.

Ce mode de réalisation d'une tête de soudage à thermodes écartables selon l'invention présente une grande flexibilité d'utilisation. En effet, il est possible d'ajuster l'écartement des deux carters 40 et 42 dans la position ouverte, ainsi que dans la position fermée et il est également possible de régler à l'intérieur d'une plage donnée de manière indépendante la position de chaque thermode relativement aux autres thermodes, en particulier de la thermode qui est fixée sur le même carter et duquel elle est solidaire pour le mouvement d'ouverture et de fermeture de cette tête de soudage.

Dans un mode de réalisation moins sophistiqué d'une tête de soudage selon l'invention, il est prévu seulement deux thermodes écartables, l'une étant solidaire du piston 50 d'un vérin 46, alors que l'autre est solidaire du cylindre 48 de ce vérin 46. Dans une variante de ce mode de réalisation, chaque thermode comprend deux pannes de soudage ayant un profil rectiligne et orientées orthogonalement l'une par rapport à l'autre, la position relative de ces deux pannes pouvant être réglable.

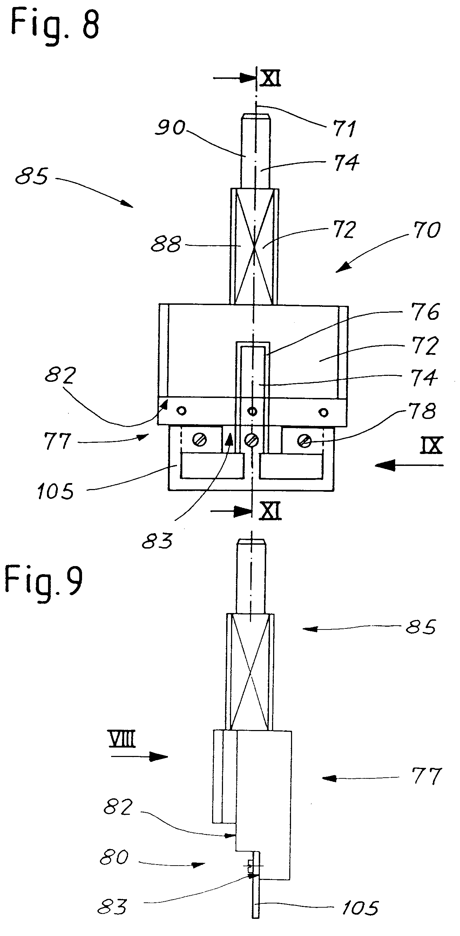

Les figures 8 et 9 montrent une thermode 70 qui est une variante de la thermode qui vient d'être décrite dans le premier mode de réalisation d'une tête de soudage selon l'invention. Cette thermode 70 définit deux pôles électriques 72 et 74 isolés électriquement l'un de l'autre par des moyens d'isolation 76. La partie inférieure 77 de cette thermode 70 présente une structure en escalier 80 définissant une première, respectivement seconde marche d'escalier 82, 83 sur l'une desquelles peut être fixée une panne de soudage au moyen de vis de fixation 78. Ceci permet de varier la grandeur de la panne de soudage 105 de telle manière que la tête de soudage selon l'invention puisse s'adapter à divers types de composants électroniques de grandeurs diverses. Dans la partie supérieure 85 de cette thermode 70, le pôle électrique 72 présente une partie de forme sensiblement rectangulaire 88, alors que le pôle électrique 74 présente une partie cylindrique 90 faisant saillie hors de la surface supérieure de la partie 88 du pôle électrique 72. Ces parties 88 et 90 sont utilisées pour fixer cette thermode 70 à l'alimentation électrique 92, comme cela est représenté sur les figures 10 et 11. On remarquera encore que la forme géométrique de la thermode 70 présente un plan de symétrie 71.

Sur les figures 10 et 11, on a représenté une thermode 70 reliée de manière rigide à son alimentation correspondante 92, lesquelles sont montées sur un porte-thermode 94 comprenant une coulisse 96 associée à un vernier 98. Ces figures représentent une unité de base 100 du premier mode de réalisation d'une tête de soudage selon l'invention, cette tête de soudage comprenant quatre unités de base similaires.

Les deux pôles électriques 72 et 74 forment, avec le bras de jonction 102 et le support 104 de la thermode 70 et de son alimentation 92, le circuit secondaire d'un transformateur de courant, l'alimentation 92 formée par une bobine définissant le circuit primaire de ce transformateur de courant. Le circuit secondaire de ce transformateur de courant est fermé au moyen de la panne de soudage 105, laquelle peut être chauffée électriquement lors du soudage.

La figure 11 présente l'unité de base 100 de la figure 10 coupée selon le plan de symétrie 71 de la thermode 70.

La coupe de la figure 11 permet ainsi de voir la structure interne de la thermode 70, ainsi que les divers éléments du porte-thermode 94.

Le porte-thermode 94 comprend une première partie 110 comprenant l'échelle fixe du vernier 98, l'échelle mobile de ce vernier 98 étant associée à une vis de réglage 112 servant à déplacer le rail 116 de la coulisse 96 sur lequel est fixé le support 104 de la thermode 70 et de son alimentation 92. La première partie 110 du porte-thermode 94 est fixée à une deuxième partie 120 formant la partie fixe de la coulisse 96, cette deuxième partie 120 présentant une section sensiblement en forme de U.

Les parties 110 et 120 de ce porte-thermode sont fixées au moyen de vis 122, alors que le rail 116 de cette coulisse 96 est fixé au support 104 au moyen de vis 124.

Les trous de vis 126 sont prévus pour fixer cette unité de base 100 au carter 40, respectivement 42.

La coulisse 96 associée au vernier 98 comprenant la vis de réglage 112 permet ainsi de varier la position de la thermode 70 relativement à la partie 110 du porte-thermode 94 pour régler avec exactitude la position de la panne de soudage 105 relativement aux autres pannes de soudage de la tête de soudage selon l'invention.

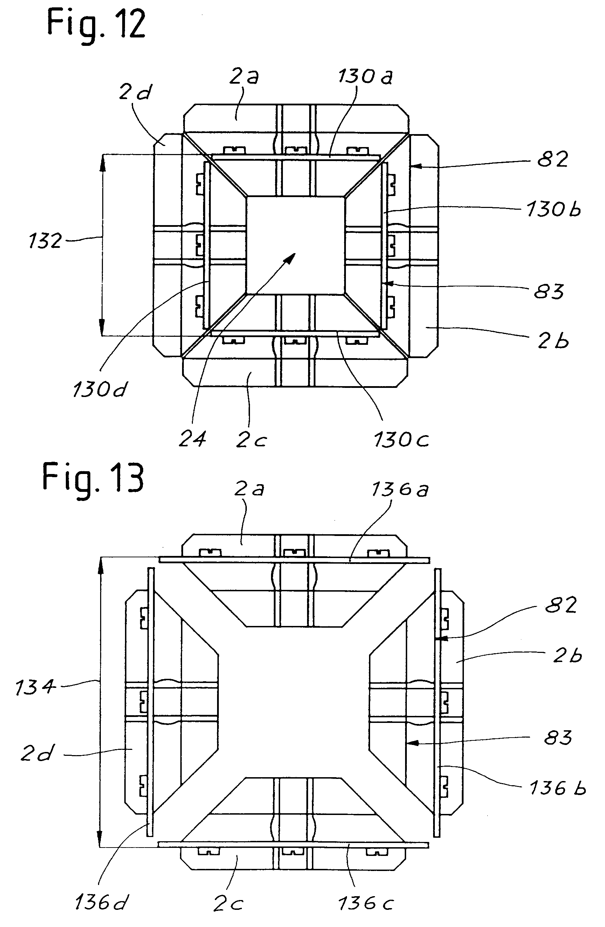

Les figures 12 et 13 représentent deux configurations possibles des pannes de soudage du premier mode de réalisation d'une tête de soudage selon l'invention décrit ci-avant. Sur la figure 12 sont fixées quatre pannes de soudage 130a à 130d sur les quatre thermodes 2a à 2d du premier mode de réalisation de la tête de soudage selon l'invention. L'écartement relatif 132 entre deux pannes opposées 130a et 130c, respectivement 130b et 130d est passablement plus petit que l'écartement relatif 134 entre les pannes 136a et 136c, respectivement 136b et 136d fixées sur les thermodes 2a et 2c, respectivement 2b et 2d de la figure 13.

Ces figures 12 et 13 montrent ainsi la grande flexibilité d'utilisation du premier mode de réalisation de la tête de soudage décrit ci-avant comprenant des thermodes semblables à celles décrites aux figures 8 et 9. On remarquera que les pannes 130a à 130d sont fixées sur la deuxième marche d'escalier 83 dans la figure 12, alors qu'elles sont fixées sur la première marche d'escalier 82 dans la figure 13.

Les configurations des pannes de soudage représentées sur les figures 12 et 13 sont adaptées à des composants électroniques de forme carrée. Cependant, il est tout à fait possible de prévoir deux paires de pannes de grandeur différente, chaque paire pouvant être fixée soit sur le niveau 82 ou sur le niveau 83 de telle manière que la configuration résultante soit adaptée au soudage de composants électroniques rectangulaires. Naturellement, la tête de soudage selon l'invention peut comprendre diverses thermodes adaptées à un composant électronique spécifique à souder.

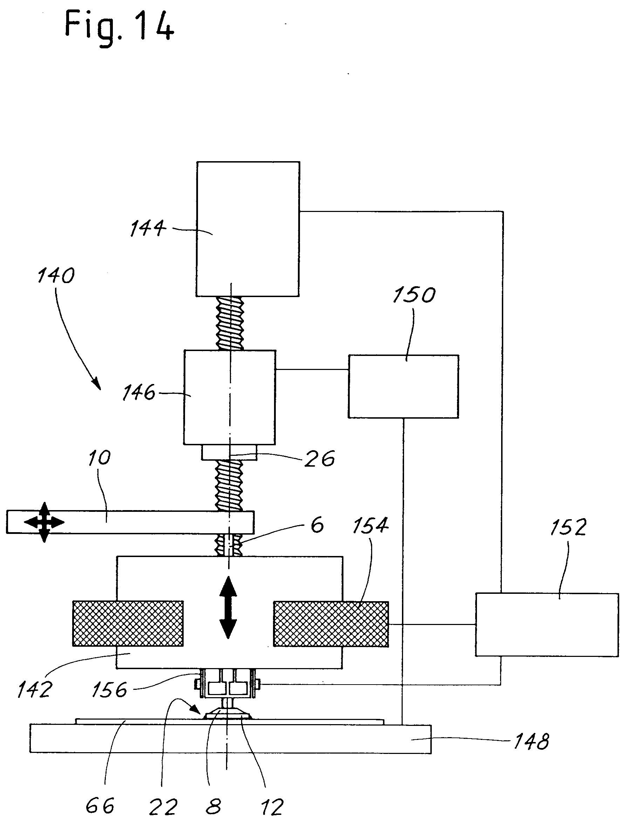

En se référant à la figure 14, on décrira ci-après schématiquement un premier mode de réalisation d'un dispositif de soudage selon l'invention.

Ce dispositif de soudage est schématisé sur cette figure 14 de manière partielle. Ce dispositif de soudage 140 comprend une tête de soudage 142 selon l'invention, ainsi qu'un élément de préhension 10 comprenant un bras terminal 6 au bout duquel se trouve un organe de préhension 8 d'un composant électronique 12.

Ce premier mode de réalisation d'un dispositif de soudage selon l'invention comprend un moteur 144 permettant à la tête de soudage 142 d'être déplacée verticalement, c'est-à-dire selon la direction de l'axe central 26. Une caméra 146 permettant une visualisation intelligente d'au moins une partie du site de soudage 22, ainsi qu'une table mobile 148 sont aussi prévues dans ce dispositif de soudage. Ensuite, un dispositif d'asservissement 150 de la table mobile 148 en fonction de l'information transmise par la caméra 146 est prévu, tout comme une commande de régulation 152 reliée au moteur 144, aux alimentations de la tête de soudage selon l'invention 142 et à des thermocouples 160 placés sur chaque panne de soudage 156 de cette tête de soudage.

## Revendications

1. Procédé de soudage d'un composant électronique sur un substrat (66) comprenant les étapes successives suivantes :
- préhension dudit composant électronique (12) sur un site de présentation par un élément de préhension (10) comprenant un bras terminal (6) perpendiculaire au plan défini par les parties de contact (16) des pattes de connexion dudit composant électronique (12);
- transfert dudit composant électronique (12) au moyen dudit élément de préhension (10) au-dessus d'un site de soudage (22) appartenant audit substrat (66), lequel comprend un ensemble de connexions externes (18) aux extrémités (20) desquelles il est prévu de souder lesdites parties de contact (16) desdites pattes de connexion (14);
- alignement desdites parties de contact (16) desdites pattes de connexion (14) avec lesdites extrémités (20) desdites connexions externes (18) au moyen d'un dispositif d'alignement (146, 148, 150);
- fermeture de thermodes écartables (2a à 2d) sur ledit bras terminal (6) dudit élément de préhension (10) de telle manière que des pannes de soudage (4) de ces thermodes écartables soient au moins partiellement superposées à au moins un ensemble desdites parties de contact desdites pattes de connexion (14) dudit composant électronique (12) et pose desdites parties de contact (16) desdites pattes de connexion (14) sur lesdites extrémités (20) desdites connexions externes (18);
- déplacement desdites thermodes écartables (2a à 2d) jusqu'à ce que les surfaces de contact (5) desdites pannes de soudage (4) desdites thermodes écartables soient en contact thermique avec lesdites parties de contact (16) desdites pattes de connexion (14) dudit composant électronique (12);
- soudage desdites parties de contact (16) desdites pattes de connexion (14) auxdites extrémités (20) desdites connexions externes (18);
- retrait desdites thermodes écartables (2a à 2d) pour éloigner lesdites pannes de soudage (4) de ces thermodes écartables desdites pattes de connexion (14) et lâcher dudit composant électronique (12).

2. Procédé de soudage selon la revendication 1, comprenant une première étape d'orientation du composant électronique (12) sur ledit site de présentation.

3. Procédé de soudage selon la revendication 1 ou 2 présentant après l'étape de retrait desdites thermodes écartables (2a à 2d) les étapes successives suivantes :
- ouverture desdites thermodes écartables (2a à 2d) pour ramener ces thermodes écartables dans ladite position ouverte;
- retour dudit élément de préhension (10) au-dessus dudit site de présentation.

4. Procédé selon l'une quelconque des revendications 1 à 3, caractérisé en ce que ledit bras terminal (6) dudit élément de préhension (10) est introduit latéralement aux thermodes écartables (2a à 2d).

5. Procédé selon la revendication 3 ou 4, caractérisé en ce que l'ouverture et la fermeture desdites thermodes écartables (2a à 2d) sont effectuées selon une direction privilégiée (23) et en ce que le déplacement et le retrait de ces thermodes écartables dans ladite position fermée, ainsi que la pose desdites parties de contact (16) desdites pattes de connexion (14) sont effectuées selon la direction d'un axe central (26) perpendiculaire au plan général dudit site de soudage (22).

6. Tête de soudage caractérisée en ce qu'elle comprend au moins deux thermodes écartables (2a à 2d) et des moyens d'ouverture et de fermeture (46, 52) capable d'engendrer un déplacement relatif d'au moins une (2a, 2b) de ces thermodes écartables par rapport à au moins une autre (2c, 2d) de ces thermodes écartables entre une position fermée correspondant à une configuration de travail des pannes de soudage de ces thermodes écartables (2a à 2d) et une position ouverte dans laquelle ces thermodes écartables sont écartées l'une de l'autre, ces thermodes définissant dans ladite position fermée une région centrale (24) entourant un axe central (26) et laissée libre pour permettre à un bras terminal (6) d'un élément de préhension (10) d'un composant électronique (12) de traverser selon la direction dudit axe central (26) de ladite région centrale (24) lorsque ladite tête de soudage est dans ladite position fermée, chacune de ces thermodes écartables (2a à 2d) étant reliée électriquement à une alimentation électrique (30a à 30d).

7. Tête de soudage selon la revendication 6, caractérisée en ce lesdits moyens d'ouverture et de fermeture (46, 52) sont formés par un vérin (46) associé à une coulisse (52).

8. Tête de soudage selon la revendication 6 ou 7, caractérisée en ce qu'elle comprend deux thermodes écartables, chacune comportant deux pannes de soudage présentant un profil rectiligne et disposées de manière orthogonale l'une par rapport à l'autre.

9. Tête de soudage selon la revendication 7, caractérisée en ce qu'elle comprend quatre thermodes écartables (2a à 2d) comportant chacune une panne de soudage (4), chacune de ces thermodes écartables (2a à 2d) définissant deux pôles électriques (72, 74) reliés électriquement à une alimentation électrique (30a à 30d) et à ladite panne de soudage (4), chaque thermode écartable étant montée sur un porte-thermode (32a à 32d), deux de ces porte-thermodes (32a, 32b) étant fixés à un premier carter (40) et les deux autres porte-thermodes (32c, 32d) étant fixés à un deuxième carter (42), ledit premier, respectivement deuxième carter (40, 42) étant solidaire du piston (50), respectivement du cylindre (48) dudit vérin (46).

10. Tête de soudage selon la revendication 9, caractérisée en ce que chacun desdits porte-thermodes (32a à 32d, 94) comprend une coulisse (36, 96) associée à un vernier (38, 98) comportant une vis de réglage (112) de la position du rail (116) de ladite coulisse, chaque alimentation électrique (30a à 30d, 92) étant propre à une seule desdites thermodes écartables et reliée rigidement à cette thermode écartable correspondante (2a à 2d, 70), chaque alimentation électrique et sa thermode correspondante étant fixées à un élément support (104) lui-même fixé audit rail (116) de ladite coulisse (36, 96) dudit porte-thermode.

11. Tête de soudage selon la revendication 9 ou 10, caractérisée en ce qu'au moins une desdites thermodes écartables (2a à 2d, 70) présente une structure en escalier (80) définissant des première et deuxième marches (82 et 83) sur lesquelles une panne de soudage (4, 105) est susceptible d'être fixée.

12. Tête de soudage selon la revendication 10 ou 11, caractérisée en ce que chacune desdites thermodes écartables (2a à 2d, 70) forme avec son alimentation électrique (30a à 30d, 92), ledit élément support (104) et un bras de jonction (102) un transformateur de courant.

13. Dispositif de soudage (140) comprenant :
- une tête de soudage (142);
- des moyens de préhension (10) d'un composant électronique (12) susceptible d'être déplacé horizontalement et verticalement par rapport à un substrat (66) destiné à recevoir ledit composant électronique;
- une table (148) destinée à supporter ledit substrat (66), cette table étant susceptible d'être déplacée dans son plan selon deux directions perpendiculaires (X, Y) et de subir une rotation (a) dans ledit plan;
- un dispositif de visualisation (146) permettant de visualiser un site de soudage;
- un moteur (144) permettant au moins un déplacement vertical selon la direction d'un axe central (26) de ladite tête de soudage (142) entre une position de soudage et une position de mise en place dudit composant électronique (12) dans laquelle ladite tête de soudage (142) est éloignée dudit substrat (66);
ce dispositif de soudage (140) étant caractérisé en ce que ladite tête de soudage (142) est une tête de soudage selon l'une quelconque des revendications 6 à 12.

14. Dispositif de soudage (140) selon la revendication 13, caractérisé en ce que ledit dispositif de visualisation (146) a un champ visuel à travers lesdites thermodes écartables de ladite tête de soudage lorsque celles-ci sont dans ladite position ouverte et selon la direction dudit axe central (26) suffisant pour visualiser les pattes de connexion dudit composant électronique maintenu au-dessus d'un site de soudage par ledit élément de préhension.

15. Dispositif de soudage (140) selon les revendications 10 et 13 ou 14, caractérisé en ce qu'il comprend une commande de régulation (152) du déplacement de ladite tête de soudage (142) et de la puissance desdites alimentations électriques desdites thermodes écartables (2a à 2d) en fonction de l'information donnée par un thermocouple (160) placé sur chacune des pannes de soudage (4) de ces thermodes écartables, ainsi que des moyens d'asservissement (150) de ladite table mobile (148) en fonction de l'information donnée par ledit dispositif de visualisation (146) capable d'effectuer une visualisation intelligente de la position des pattes de connexion dudit composant électronique (12) relativement aux extrémités de connexions externes correspondantes dudit substrat (66).
